# EUROPEAN PATENT APPLICATION

(11) **EP 4 786 517 A1**
(43) Date of publication of application: **05.08.2026**
(21) Application number: 26153430.9
(22) Date of filing: 22.01.2026
(51) Int. Cl.: C08G 59/40, C08G 59/50, C08G 59/68, C08L 63/00, C08L 79/08, H05K 1/03

(54) **HEAT-CURABLE CYCLIC IMIDE RESIN COMPOSITION, AND BONDING FILM, BUILD-UP FILM, RESIN-COATED COPPER FOIL, PREPREG, LAMINATE, AND PRINTED WIRING BOARD USING THEM**

(30) Priority: 04.02.2025 JP 2025016893
(71) Applicant: SHIN-ETSU CHEMICAL CO., LTD.,, Chiyoda-ku, Tokyo 1000005 (JP)
(72) Inventor: Tsutsumi, Yoshihiro, 3790224 Gunma (JP); Kudo, Shunsuke, 3790224 Gunma (JP); Hosokawa, Daiki, 3790224 Gunma (JP)
(74) Representative: Angerhausen, Christoph

(57) **Abstract**

Provided is a heat-curable cyclic imide resin composition that provides a cured product having low relative permittivity, low dielectric loss tangent, excellent bonding properties, and, in particular, excellent desmear resistance. The heat-curable cyclic imide resin composition contains (A) an aromatic cyclic imide resin having a weight average molecular weight of 5,000 to 100,000, (B) an aliphatic cyclic imide resin having a weight average molecular weight of 100 to 2,000, (C) an epoxy resin containing two or more epoxy groups in one molecule, (D) an epoxy resin-curing agent, (E) an imidazole compound having a triazine frame, and (F) a hollow inorganic filler. The composition contains the components (A) to (E) in a total amount of 5 to 99% by mass of the whole composition.

## Description

### BACKGROUND OF THE INVENTION

### Field of the Invention

The present invention relates to a heat-curable cyclic imide resin composition.

### Background Art

In recent years, the next-generation communication system called 5G (26 to 80 GHz millimeter wave band) has become popular, and the development of the next-next-generation communication system called 6G has started. In order to realize communication systems of higher speed, larger capacity, and reduced communication delay than the current levels, materials for high frequency bands of 3 to 80 GHz are required, and low transmission loss is essential as a countermeasure against noise. The transmission loss is the sum of conductor loss and dielectric loss. Reducing the conductor loss requires low surface roughness of metal foils that are used, in particular, copper foils. On the other hand, the dielectric loss is proportional to the product of the square root of relative permittivity, multiplied by the dielectric loss tangent. Thus, insulating materials of excellent dielectric properties (low relative permittivity and low dielectric loss tangent) are to be developed. In particular, insulating materials for board applications are required to be superior in such dielectric properties. Materials known as reactive polyphenylene ether resins (PPE) are increasingly used for rigid boards. Materials called liquid crystal polymers (LCP) and modified polyimides (MPI) are increasingly used for flexible printed circuit (FPC) boards.

In board fabrication processes called the semi-additive process (SAP) and the modified semi-additive process (M-SAP), heat-curable films are used to form insulating films called build-up films (interlayer stacking materials), and adhesive films (bonding films) are used to improve the adhesion of the heat-curable films with boards and metals. Epoxy resins are used in these materials, and active ester curing agents are frequently used in recent years to improve dielectric properties (see JP-A-2024-37078).

On the other hand, heat-curable resin compositions for board applications that employ a maleimide compound substantially having a dimer diamine frame (hereinafter, such compounds are written as "special maleimide compounds") have been reported (see WO-A-2016-114287 and JP-A-2018-201024). In contrast to conventional maleimide resins, the special maleimide compounds are low in glass transition temperature (Tg) and high in coefficient of thermal expansion (CTE). In spite of these facts, such special maleimide compounds have been extensively researched and developed because of the numerous advantages they offer. For example, compared to the existing heat-curable resins, special maleimide compounds are highly excellent in dielectric properties, have flexible properties, outperform epoxy resins in adhesion to metals or the like, and can be built up high into a multilayer structure utilizing the heat-curable properties of the resins.

Novel build-up films and bonding films have been developed by making use of the properties of special maleimide compounds (see JP-A-2020-83898). Special maleimide compounds are used mainly to lower the dielectric loss tangent of cured products and to enhance the adhesion to metals, in particular, copper. In particular, special maleimide compounds are added to the existing epoxy resin compositions to improve dielectric loss tangent and adhesion. Furthermore, studies on special maleimide compounds have recently shown that the wet desmearing process after via formation can benefit from easy removal of smears (desmearing) and can form clean vias.

On the other hand, in-depth studies on special maleimide compounds have also shown problems. While the adhesion of materials is generally lowered with decreasing roughness of the surface of copper foils, special maleimide compounds exhibit sufficiently high adhesion even with respect to such copper foils. However, the resin, when spread on a copper foil with excessively low surface roughness, is excessively melted in the desmearing process to allow the etchant to penetrate deep into the interface between the resin and the copper foil, with the result that the resin is easily detached from the copper foil.

These problems are approached through the use of high-molecular aromatic maleimide compounds (see JP-A-2021-17485), other cyclic imide compounds, and epoxy resins. Unfortunately, these compounds are insufficient in dielectric properties and, in particular, will not offer low relative permittivity. Furthermore, compositions including these heat-curable resins are combined with inorganic fillers, such as silica, to reduce the coefficient of thermal expansion (CTE). However, inorganic fillers in general have high relative permittivity.

Under the circumstances discussed above, heat-curable resin compositions containing hollow inorganic particles have recently been reported (see JP-A-2020-83966 and JP-A-2024-92800). However, heat-curable resin compositions that fully address all of these requirements have yet to be developed.

### SUMMARY OF THE INVENTION

Accordingly, it is an object of the present invention to provide a heat-curable resin composition that provides a cured product having low relative permittivity, low dielectric loss tangent, excellent bonding properties, and, in particular, excellent desmear resistance (etchant resistance). A further object of the present invention is to provide a bonding film, a prepreg, a copper foil, a build-up film, a laminate, and a printed wiring board each including or having the composition.

The inventors of the present invention carried out extensive studies directed to solving the problems discussed above and have consequently found that a heat-curable resin composition as set forth below can achieve the above objects, thus completing the present invention.
<1> A heat-curable cyclic imide resin composition comprising:
   (A) an aromatic cyclic imide resin having a weight average molecular weight of 5,000 to 100,000;
   (B) an aliphatic cyclic imide resin having a weight average molecular weight of 100 to 2,000;
   (C) an epoxy resin containing two or more epoxy groups in one molecule;
   (D) an epoxy resin-curing agent;
   (E) an imidazole compound having a triazine frame; and
   (F) a hollow inorganic filler,
   wherein the heat-curable cyclic imide resin composition contains the components (A) to (E) in a total amount of 5 to 99% by mass of the whole composition.
<2> The heat-curable cyclic imide resin composition according to <1>, wherein the aromatic cyclic imide resin (A) comprises one or more aromatic cyclic imides selected from formulas (1) and (2) defined as: 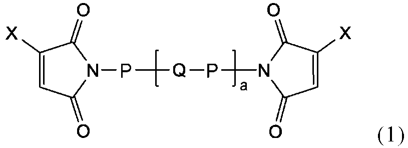
   wherein, in the formula (1), a is a number of 1 to 40, X is a hydrogen atom or a methyl group, and P and Q independently represent divalent groups respectively represented by formulas:
      - P:: 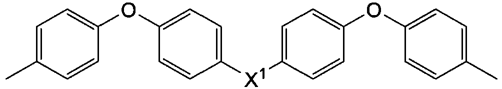
      - Q:: 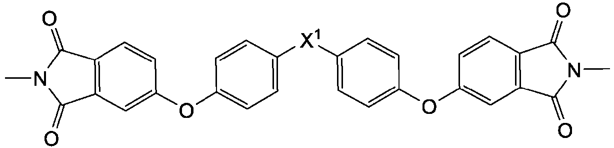
      wherein each X¹ independently represents a divalent group selected from formulas listed as 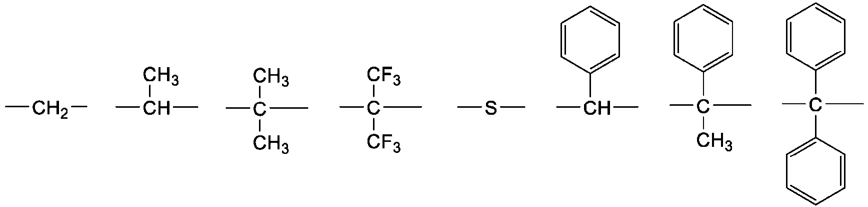 ; and 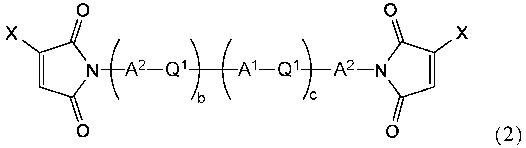
   wherein, in the formula (2), X is a hydrogen atom or a methyl group, b is a number of 1 to 50, c is a number of 1 to 50, each Q¹ independently represents a divalent group represented by formula defined as:
      - Q¹:: 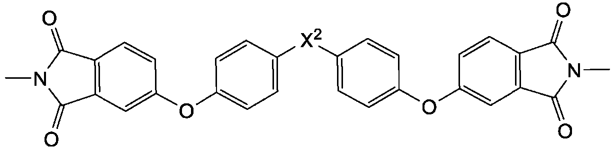
      wherein each X² independently represents a divalent group selected from formulas listed as: 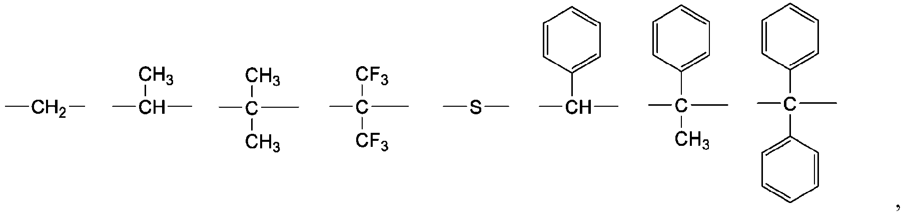 and
   wherein A¹ and A² are each independently represented by formula (3) or (4) defined as: 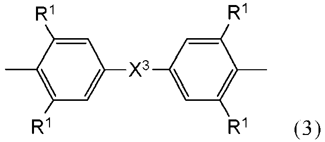 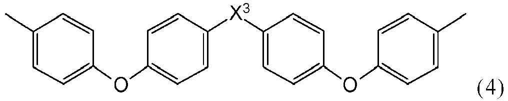 wherein each R¹ in the formula (3) independently represents a hydrogen atom, a chlorine atom, or an aliphatic hydrocarbon group having 1 to 6 carbon atoms and each X³ in the formulas (3) and (4) independently represents a divalent group selected from formulas listed as: 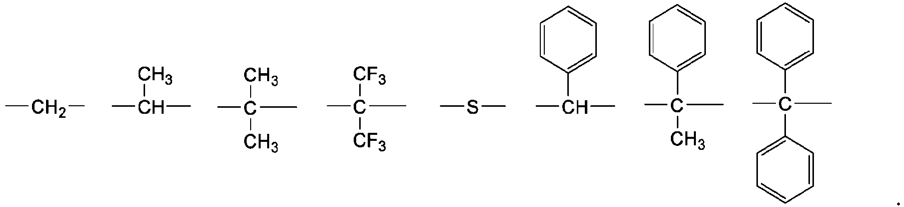
<3> The heat-curable cyclic imide resin composition according to <1> or <2>, wherein the aliphatic cyclic imide resin (B) is an aliphatic cyclic imide resin represented by formula (5) defined as: 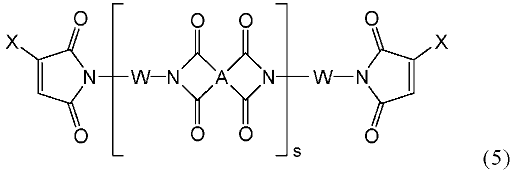 wherein each A independently represents a tetravalent organic group having an aliphatic cyclic structure, X is a hydrogen atom or a methyl group, each W independently represents a divalent aliphatic hydrocarbon group having 5 to 25 carbon atoms and optionally containing a heteroatom, and s is 0 to 10.
<4> The heat-curable cyclic imide resin composition according to <3>, wherein the divalent aliphatic hydrocarbon group represented by W in the formula (5) is a linear or branched alkylene group having 5 to 25 carbon atoms or a divalent aliphatic hydrocarbon group represented by any one of the structural formulas defined as: 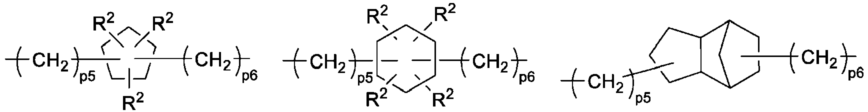 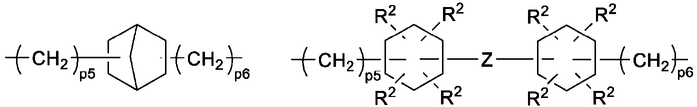 wherein p⁵ and p⁶ are each a number of 0 or greater and are the same as or different from each other, each R² independently represents a hydrogen atom or a linear or branched alkyl group having 1 to 20 carbon atoms, Z is an oxygen atom, a sulfur atom, or a methylene group, and the valence bonds that are not bonded to any substituents in the structural formulas are bonded to the nitrogen atoms constituting the cyclic imide structures in the formula (5).
<5> The heat-curable cyclic imide resin composition according to any one of <1> to <4>, wherein the composition contains 5 to 250 parts by mass of the component (B) per 100 parts by mass of the component (A).
<6> The heat-curable cyclic imide resin composition according to any one of <1> to <5>, wherein the epoxy resin-curing agent (D) is an amine compound.
<7> The heat-curable cyclic imide resin composition according to any one of <1> to <6>, wherein the hollow inorganic filler (F) comprises one or more selected from hollow silica and hollow glass.
<8> The heat-curable cyclic imide resin composition according to <7>, wherein the hollow inorganic filler (F) is treated with a silane coupling agent.
<9> The heat-curable cyclic imide resin composition according to any one of <1> to <8>, further comprising (G) a nonhollow inorganic filler.
<10> A bonding film comprising the heat-curable cyclic imide resin composition according to any one of <1> to <9>.
<11> A build-up film comprising the heat-curable cyclic imide resin composition according to any one of <1> to <9>.
<12> A resin-coated copper foil comprising the heat-curable cyclic imide resin composition according to any one of <1> to <9>.
<13> A prepreg comprising the heat-curable cyclic imide resin composition according to any one of <1> to <9>.
<14> A laminate comprising the heat-curable cyclic imide resin composition according to any one of <1> to <9>.
<15> A printed wiring board using any one of: the bonding film according to <10>, the build-up film according to <11>, the resin-coated copper foil according to <12>, the prepreg according to <13>, and the laminate according to <14>.

The heat-curable resin composition of the present invention can provide a cured product that has low relative permittivity, low dielectric loss tangent, excellent bonding properties, and, in particular, excellent desmear resistance (etchant resistance). Furthermore, the composition of the present invention is useful in bonding films, prepregs, copper foils, build-up films, laminates, and printed wiring boards, and is particularly useful in bonding films and build-up films for high-speed communication applications.

In the present invention, bonding films are also referred to as adhesive films and are used in, for example, bonding between a flexible board core material and a cover lay film, bonding between a rigid board core material and a copper foil or a build-up film, and bonding between core materials. Build-up films are also referred to as interlayer insulating materials and are used in micro wiring-forming layers in boards.

### DETAILED DESCRIPTION OF THE INVENTION

Hereinafter, the present invention will be described in greater detail. [(A) Aromatic cyclic imide resins having a weight average molecular weight of 5,000 to 100,000]

The component (A) is an aromatic cyclic imide resin having a weight average molecular weight of 5,000 to 100,000. Here, the aromatic cyclic imide resin has a cyclic imide group directly bonded to an aromatic ring. The use of the aromatic cyclic imide resin improves handling properties of uncured resin films and provides cured products having enhanced heat resistance and desmear resistance.

The aromatic cyclic imide resin as the component (A) is preferably one or more aromatic cyclic imides selected from formulas (1) and (2) defined as: 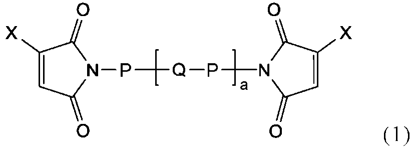 wherein a is a number of 1 to 40, X is a hydrogen atom or a methyl group, and P and Q are independently divalent groups respectively represented by formulas:
- P:: 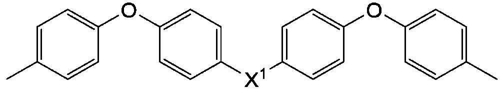
- Q:: 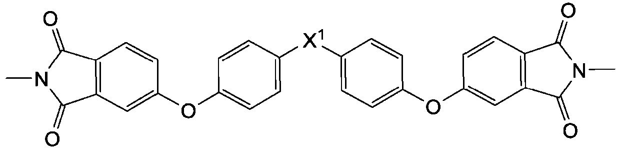
wherein each X¹ independently represents a divalent group selected from the following formulas:

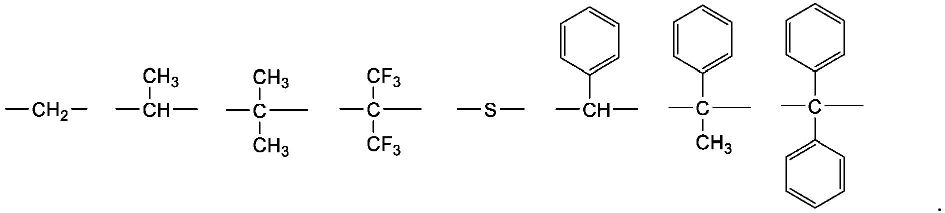

From the point of view of the availability of raw materials, X¹ in the formula (1) is preferably -CH₂- or -C(CH₃)₂-.

In the formula (1), a is a number of 1 to 40, and preferably a number of 5 to 30.

In the formula (1), X is a hydrogen atom or a methyl group, and is preferably a hydrogen atom.

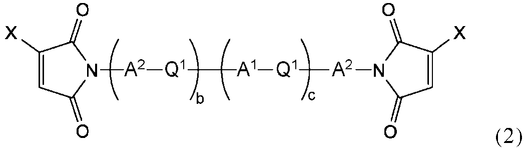

In the formula (2), b is a number of 1 to 50, c is a number of 1 to 50, X is a hydrogen atom or a methyl group, and each Q¹ independently represents a divalent group represented by formula defined as:
- Q¹:: 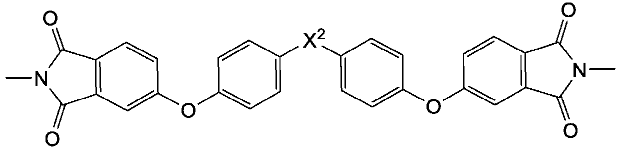
wherein each X² independently represents a divalent group selected from formulas as listed below: 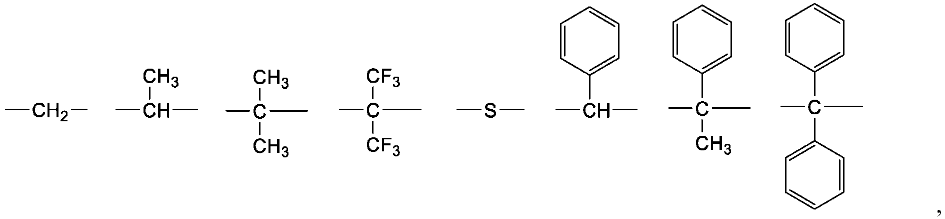 and wherein A¹ and A² are each independently represented by formula (3) or (4) defined as: 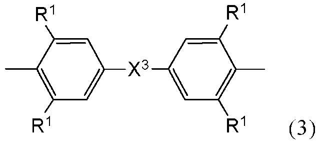 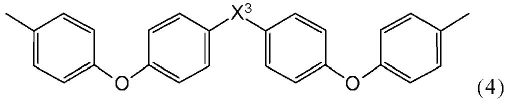 wherein each R¹ independently represents a hydrogen atom, a chlorine atom, or an aliphatic hydrocarbon group having 1 to 6 carbon atoms and each X³ independently represents a divalent group selected from formulas listed below:

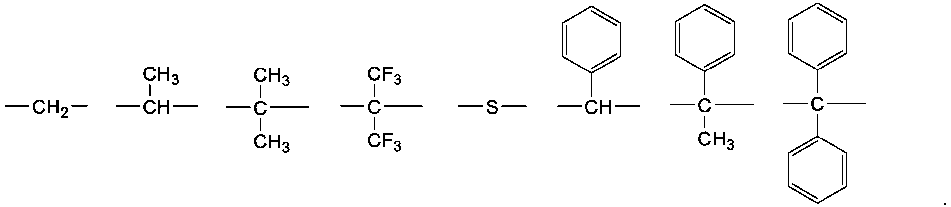

From the point of view of the availability of raw materials, X² in the formula (2) is preferably -CH₂- or -C(CH₃)₂-.

In the formula (2), b is a number of 1 to 50, and preferably a number of 1 to 40.

In the formula (2), c is a number of 1 to 50, and preferably a number of 1 to 40.

In the formula (2), A¹ and A² are each independently a group represented by the formula (3) or (4).

From the point of view of the availability of raw materials, X³ in the formulas (3) and (4) is preferably -CH₂- or -C(CH₃)₂-.

In the formula (3), each R¹ independently represents a hydrogen atom, a chlorine atom, or an aliphatic hydrocarbon group having 1 to 6 carbon atoms.

Examples of the aliphatic hydrocarbon groups having 1 to 6 carbon atoms represented by R¹ in the formula (3) include a methyl group, an ethyl group, an n-propyl group, an isopropyl group, an n-butyl group, a t-butyl group, and a cyclohexyl group. These groups may be substituted by halogen atoms, such as F, Cl, and Br, in place of part or all of the hydrogen atoms of these groups. That is, the groups may have, for example, trifluoromethyl groups. From the point of view of the availability of raw materials, R¹ is preferably a hydrogen atom or an aliphatic hydrocarbon group having 1 to 3 carbon atoms. Similarly to the formula (1), X is a hydrogen atom or a methyl group, and is preferably a hydrogen atom.

In the aromatic cyclic imide resin represented by the formula (2), it is preferable that A¹ and A² be groups different from each other. When, for example, A¹ in the formula (2) is a group represented by the formula (3), A² is preferably a group represented by the formula (4). When, for example, A¹ is a group represented by the formula (4), A² is preferably a group represented by the formula (3).

In the cyclic imide resin represented by the formula (2), the repeating units with the subscript b and the repeating units with the subscript c may be bonded to one another randomly or blockwise. From the points of view of the mechanical strength and dielectric properties (in particular, low dielectric loss tangent) of cured products, these repeating units are preferably bonded blockwise.

By virtue of having a bisphenol structure in the molecule, the aromatic cyclic imide resins represented by the formula (1) and the aromatic cyclic imide resins represented by the formula (2) can be produced without using N-methylpyrrolidone (NMP). Furthermore, these resins excel in solubility in solvents and are soluble in solvents other than NMP. Furthermore, the cyclic imide resins having a bisphenol structure are also beneficial from the point of view of, for example, the availability of raw materials. For example, the bisphenol structures present in the aromatic cyclic imide resins represented by the formula (1) and the aromatic cyclic imide resins represented by the formula (2) may be bisphenol A, bisphenol F, bisphenol E, or bisphenol AF, and are preferably bisphenol A or bisphenol F, although not particularly limited thereto. As long as the aromatic cyclic imide resins represented by the formula (1) and the aromatic cyclic imide resins represented by the formula (2) satisfy the aforementioned ranges of a, b, and c, good balance can be achieved between the solubility in solvents and film properties in an uncured state, and the toughness and the heat resistance of cured products that are obtained.

The weight average molecular weight of the aromatic cyclic imide resin as the component (A) is 5,000 to 100,000, preferably 7,000 to 80,000, and more preferably 8,000 to 60,000. When the weight average molecular weight is in this range, the aromatic cyclic imide resin as the component (A) is dissolved stably in a solvent and ensures wetting properties with respect to substrates. Furthermore, films before curing are unlikely to suffer problems, such as cracks, and are of good quality. The term "weight average molecular weight" as used herein refers to a weight average molecular weight measured by gel permeation chromatography (GPC) relative to polystyrene standards under the conditions below.

### [GPC measurement conditions]

Developing solvent: tetrahydrofuran
Flow rate: 0.35 mL/min
Detector: differential refractometer (RI)
Column: TSK-GEL H type (manufactured by Tosoh Corporation)
Column temperature: 40°C
Sample injection volume: 5 µL (0.2% by mass THF solution)

For example, the aromatic cyclic imide resin represented by the formula (1) or (2) as the component (A) may be produced by the method described in JP-A-2021-017485.

The aromatic cyclic imide resins as the components (A) may be used alone, or two or more of them may be used in combination.

The amount in which the component (A) is added is preferably 5 to 70% by mass, more preferably 5 to 60% by mass, and particularly preferably 6 to 50% by mass of the composition of the present invention.

### [(B) Aliphatic cyclic imide resins having a weight average molecular weight of 100 to 2,000]

The component (B) is an aliphatic cyclic imide resin having a weight average molecular weight of 100 to 2,000. Here, the aliphatic cyclic imide resin is such that the linker connecting two cyclic imide groups is exclusively an aliphatic chain and has no aromatic rings. The linker may contain a heteroatom. Examples of the heteroatoms include oxygen atom, nitrogen atom, and sulfur atom. The use of the aliphatic cyclic imide resin improves the formability of uncured resin films and lowers the melt viscosity of the resin composition, which therefore enhances laminating properties and formability. Furthermore, the use of the aliphatic cyclic imide resin effectively enhances the adhesion to metals, such as copper, and is also effective for achieving reduced dielectric properties.

The aliphatic cyclic imide resin as the component (B) is preferably an aliphatic cyclic imide resin represented by formula (5) defined as: 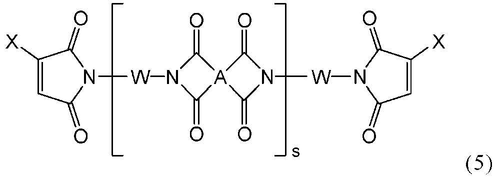 wherein, in the formula (5), each A independently represents a tetravalent organic group having an aliphatic cyclic structure, X is a hydrogen atom or a methyl group, each W independently represents a divalent aliphatic hydrocarbon group having 5 to 25 carbon atoms and optionally containing a heteroatom, and s is 0 to 10.

In the formula (5), each A independently represents a tetravalent organic group having an aliphatic cyclic structure, and X is a hydrogen atom or a methyl group, and is preferably a methyl group from the point of view of lowering the viscosity.

In the formula (5), each W independently represents a linear or branched alkylene group having 5 to 25 carbon atoms or a divalent aliphatic hydrocarbon group represented by any of the following structural formulas, and is preferably a linear or branched alkylene group having 6 to 20 carbon atoms, and more preferably a branched alkylene group having 6 to 20 carbon atoms.

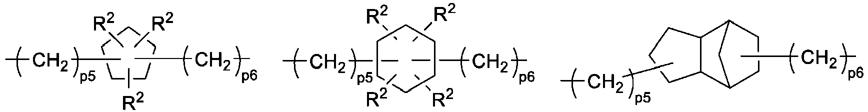

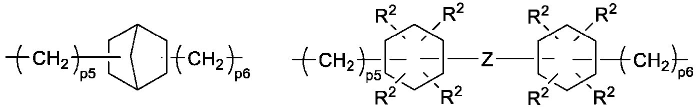

In the above structural formulas, p⁵ and p⁶ are each a number of 0 to 4, and are the same as or different from each other, each R² independently represents a hydrogen atom or a linear or branched alkyl group having 1 to 20 carbon atoms, Z is an oxygen atom, a sulfur atom, or a methylene group, and the valence bonds that are not bonded to any substituents in the structural formulas are bonded to the nitrogen atoms constituting the cyclic imide structures in the formula (5).

In the above formulas, p⁵ and p⁶ are each a number of 0 to 4, preferably each a number of 0 to 2, and are the same as or different from each other. Each R² independently represents a hydrogen atom or a linear or branched alkyl group having 1 to 20 carbon atoms, preferably a hydrogen atom or a linear or branched alkyl group having 1 to 10 carbon atoms, and more preferably a hydrogen atom or a linear alkyl group having 1 to 10 carbon atoms. Z is an oxygen atom, a sulfur atom, or a methylene group.

In the formula (5), s is 0 to 10, preferably 0 to 5, more preferably 0 to 3, and still more preferably s = 0.

The weight average molecular weight (Mw) of the aliphatic cyclic imide resin represented by the formula (5) is 100 to 2,000, preferably 250 to 1,500, and more preferably 300 to 1,000. If the weight average molecular weight is larger than 2,000, the resin composition will not have a low melt viscosity at high temperatures and consequently may exhibit poor formability and bonding properties.

The aliphatic cyclic imide resins as the components (B) may be used alone, or two or more of them may be used in combination.

The amount in which the component (B) is added is preferably 10 to 100 parts by mass, more preferably 12 to 90 parts by mass, and particularly preferably 15 to 80 parts by mass per 100 parts by mass of the component (A).

### [(C) Epoxy resins containing two or more epoxy groups in one molecule]

In the heat-curable resin composition of the present invention, an epoxy resin containing two or more epoxy groups in one molecule is used as the component (C). The addition of such an epoxy resin makes it possible to increase the adhesion of the resin composition and to improve other mechanical properties.

In consideration of, for example, reactivity and storage properties, the component (C) is preferably an epoxy resin having glycidyl groups.

Examples of such components (C) include phenol novolac-type epoxy resins, bisphenol A-type epoxy resins, bisphenol F-type epoxy resins, biphenol-type epoxy resins, naphthalene-type epoxy resins, anthracene-type epoxy resins, naphthol-type epoxy resins, xylylene-type epoxy resins, biphenyl-type epoxy resins, biphenyl aralkyl-type epoxy resins, triphenylmethane-type epoxy resins, alicyclic epoxy resins, glycidylamine-type epoxy resins, dicyclopentadiene-type epoxy resins, stilbene-type epoxy resins, sulfur atom-containing epoxy resins, and phosphorus atom-containing epoxy resins.

From the points of view of compatibility and wetting properties with respect to substrates, the component (C) is preferably one that is liquid at room temperature (25°C), and is more preferably a glycidylamine-type epoxy resin.

The amount in which the component (C) is added is preferably 0.05 to 25 parts by mass, and more preferably 0.1 to 20 parts by mass per 100 parts by mass of the total of the components (A) and (B). This range advantageously ensures that the curing rate at the time of forming is appropriate. Furthermore, cured products that are obtained will have a good balance between heat resistance and moisture resistance and will attain the intended low dielectric properties.

The epoxy resins as the components (C) may be used alone, or two or more of them may be used in combination.

### [(D) Epoxy resin-curing agents]

In the heat-curable resin composition of the present invention, an epoxy resin-curing agent is used as the component (D). The addition of the epoxy resin-curing agent makes it possible to improve mechanical properties, control curability, and reduce the influence of moisture absorption. Examples of the epoxy resin-curing agents include phenol curing agents, amine curing agents, acid anhydride curing agents, and active ester curing agents.

In consideration of, for example, reactivity and storage properties, the component (D) is preferably an amine curing agent. The amine curing agent is preferably an amine compound, and more preferably an aromatic amine compound. Aliphatic amine compounds have so high nucleophilicity that storage properties may be significantly lowered and cured products may exhibit high hygroscopicity.

The amount in which the component (D) is added is preferably 0.05 to 25 parts by mass, and more preferably 0.1 to 20 parts by mass per 100 parts by mass of the total of the components (A) and (B).

The epoxy resin-curing agents as the components (D) may be used alone, or two or more of them may be used in combination.

### [(E) Imidazole compounds having a triazine frame]

The component (E) is an imidazole compound having a triazine frame and is used as a catalyst and a curing accelerator for promoting the curing reaction of the heat-curable resin composition of the present invention. The component (E) is added to initiate and promote the crosslinking reaction of the cyclic imide resins as the components (A) and (B), the epoxy resin as the component (C), and the curing agent as the component (D). The component (E) serves as an anionic polymerization initiator.

Generally used thermal radical polymerization initiators induce the crosslinking of cyclic imide resins, preferentially of maleimide compounds (the formulas (1) and (2) in which X = H). Generally used quaternary onium salts preferentially promote the crosslinking of epoxy resins and epoxy resin-curing agents. Thus, the use of these polymerization initiators may cause the curing of the resin composition to proceed locally and may result in partial curing failure.

In contrast, anionic polymerization initiators, for example, basic compounds, such as imidazoles and tertiary amines, and organic phosphorus compounds, advantageously promote uniform crosslinking of the components. Furthermore, the use of an imidazole compound having a triazine frame enhances the storage stability of the heat-curable resin composition of the present invention, and the triazine frame effectively enhances adhesion, in particular, adhesion to metals.

The component (E) is preferably added in an amount of 0.05 to 10 parts by mass, more preferably 0.1 to 5 parts by mass per 100 parts by mass of the components (A) to (D). In the case where an additional heat-curable resin described later is added to the composition, the component (E) is preferably added in the range of 0.05 to 10 parts by mass, in particular, 0.1 to 5 parts by mass per 100 parts by mass of the total of the components (A) to (D) and the additional heat-curable resin component. This range advantageously ensures that the heat-curable resin composition of the present invention will exhibit stable curability at the time of forming. Furthermore, cured products that are obtained will have a good balance between heat resistance and moisture resistance. The components (E) may be used alone, or two or more of them may be used in combination. A polymerization initiator other than the components (E) may be used in combination so long as it does not impede the functionality and effects of the present invention.

In the heat-curable resin composition of the present invention, the components (A) to (E) account for 5 to 99% by mass, preferably 10 to 90% by mass, and more preferably 20 to 80% by mass of the whole composition.

### [(F) Hollow inorganic fillers]

The heat-curable resin composition of the present invention further contains a hollow inorganic filler as the component (F). While a nonhollow inorganic filler, which will be described later, is added for increasing the strength and the rigidity of cured products of the composition and also for controlling the coefficient of thermal expansion, and the dimensional stability of cured products, nonhollow inorganic fillers generally have high relative permittivity. A hollow inorganic filler may be used to reduce the relative permittivity.

Any type of hollow inorganic fillers may be used without particular limitation. From such points of view as the strength of particles and availability, preferable examples of such hollow inorganic fillers include hollow silica or hollow glass, and hollow silica is more preferable. Hollow silica and hollow glass may be used alone or in combination.

The hollow inorganic filler may have any average particle size and shape which are not particularly limited. However, from the point of view of board processability, in particular, spherical hollow silica having an average particle size of 0.1 to 5 µm is favorably used. The average particle size as used herein refers to a value determined as the mass average D₅₀ (or median diameter) by particle size distribution measurement using laser light diffractometry.

The void content of the hollow inorganic filler is preferably 20 to 90% by volume, and more preferably 30 to 80% by volume. When the void content is in this range, cured products of the heat-curable resin composition have low relative permittivity and low dielectric loss tangent and have a good balance between strength and dimensional stability of the cured products. If, for example, the void content is too low, the relative permittivity is not sufficiently reduced. If the void content is too high, the particles are low in strength and prone to breakage, and tend to fail to provide the intended effects. Here, the void content refers to the volume percentage of spaces in the particles relative to the volume of the inorganic filler.

In order to improve the properties of the hollow inorganic filler, it is preferred that the hollow inorganic filler be surface-treated with a silane coupling agent that has an organic group capable of reacting with the functional groups in the components (A) to (D). Examples of such silane coupling agents include epoxy group-containing alkoxysilanes, amino group-containing alkoxysilanes, (meth)acrylic group-containing alkoxysilanes, and alkenyl group-containing alkoxysilanes.

Preferred silane coupling agents are (meth)acrylic group- and/or amino group-containing alkoxysilanes, and specific examples thereof include 3-methacryloxypropyltrimethoxysilane, 3-acryloxypropyltrimethoxysilane, N-phenyl-3-aminopropyltrimethoxysilane, N-2-(aminoethyl)-3-aminopropyltrimethoxysilane, and 3-aminopropyltrimethoxysilane. The silane coupling agents may be used alone, or two or more of them may be used in combination.

In the heat-curable resin composition of the present invention, the component (F) accounts for 1 to 95% by mass, preferably 3 to 55% by mass, and more preferably 5 to 50% by mass of the whole composition.

The components (F) may be used alone, or two or more of them may be used in combination.

### [(G) Nonhollow inorganic fillers]

The heat-curable resin composition of the present invention may further contain a nonhollow inorganic filler as the component (G). As explained earlier, the nonhollow inorganic fillers tend to raise the relative permittivity of cured products of the heat-curable resin composition of the present invention. However, adding nonhollow inorganic fillers is still acceptable because nonhollow inorganic fillers outperform the hollow inorganic fillers in the ability of increasing strength and rigidity and controlling the coefficient of thermal expansion, and the dimensional stability of cured products. The heat-curable resin composition that combines the components (F) and (G) is very likely to attain well-balanced properties, such as mechanical properties.

The component (G) may be any nonhollow inorganic filler usually added to an epoxy resin composition or a silicone resin composition. In order to reduce the dielectric loss tangent while avoiding an excessively high relative permittivity of the whole composition, silica particles, such as spherical silica, molten silica, or crystalline silica, or boron nitride is preferable.

Similarly to the component (F), the nonhollow inorganic filler may have any average particle size or shape which is not particularly limited. However, from the point of view of board processability, it is particularly preferred that spherical silica having an average particle size of 0.1 to 5 µm be used. The average particle size refers to the mass average D₅₀ (or median diameter) as determined by particle size distribution measurement using laser diffraction.

Similarly to the component (F), in order to improve the properties of the nonhollow inorganic filler, it is preferred that the nonhollow inorganic filler be surface-treated with a silane coupling agent that has an organic group capable of reacting with the functional groups in the components (A) to (D). Examples of such silane coupling agents include epoxy group-containing alkoxysilanes, amino group-containing alkoxysilanes, (meth)acrylic group-containing alkoxysilanes, and alkenyl group-containing alkoxysilanes.

Preferred silane coupling agents are (meth)acrylic group-containing alkoxysilanes and amino group-containing alkoxysilanes, and specific examples thereof include 3-methacryloxypropyltrimethoxysilane, 3-acryloxypropyltrimethoxysilane, N-phenyl-3-aminopropyltrimethoxysilane, N-2-(aminoethyl)-3-aminopropyltrimethoxysilane, and 3-aminopropyltrimethoxysilane. The silane coupling agents may be used alone, or two or more of them may be used in combination.

When the component (G) is added to the heat-curable resin composition of the present invention, the amount thereof is 1 to 60% by mass, preferably 5 to 55% by mass, and more preferably 10 to 50% by mass of the whole composition. The components (G) may be used alone, or two or more of them may be used in combination.

### [Other additives]

Where necessary, various additives may be added to the heat-curable resin composition of the present invention. Such additional additives will be described below.

### [Heat-curable resins having a reactive group capable of reacting with a maleimide group]

In the present invention, heat-curable resins having a reactive group capable of reacting with the components (A) to (D) may be further added. The types of such resins are not particularly limited, and various resins may be used, and examples thereof include melamine resins, silicone resins, cyclic imide resins other than the components (A) and (B), urea resins, heat-curable polyimide resins, modified polyphenylene ether resins, heat-curable acrylic resins, and epoxy-silicone hybrid resins.

Examples of the reactive groups capable of reacting with a cyclic imide group include cyclic imide groups, hydroxyl groups, acid anhydride groups, alkenyl groups, such as allyl groups and vinyl groups, (meth)acrylic groups, and thiol groups. From the point of view of reactivity, the reactive groups are preferably those selected from cyclic imide groups, hydroxyl groups, and alkenyl groups. From the point of view of dielectric properties, the reactive groups are more preferably alkenyl groups or (meth)acrylic groups.

The amount of this heat-curable resin is preferably 0 to 40% by mass of the whole of the heat-curable resin composition of the present invention.

Other additives may be further added, and examples thereof include non-functional silicone oils, reactive diluents, thermoplastic resins, thermoplastic elastomers, organic synthetic rubbers, photosensitizers, light stabilizers, polymerization inhibitors, flame retardants, pigments, dyes, adhesion aids, and ion trapping agents.

The silane coupling agents described above, such as epoxy group-containing alkoxysilanes, amino group-containing alkoxysilanes, (meth)acrylic group-containing alkoxysilanes, and alkenyl group-containing alkoxysilanes, for use in the surface treatment of the hollow inorganic fillers and the nonhollow inorganic fillers may be separately added to the heat-curable resin composition of the present invention. Specific examples of the silane coupling agents include those same as described above.

The heat-curable resin composition of the present invention may be handled as a varnish or slurry in an organic solvent. The composition formed into a varnish is easy to produce films and is also easy to apply to and impregnate a glass cloth made of E-glass, low-permittivity glass, quartz glass, or the like. The organic solvent to be used may be any organic solvent without limitation as long as the solvent can dissolve the components (A) to (D) and the optional heat-curable resins having a reactive group capable of reacting with the components (A) to (D). Examples thereof include anisole, tetralin, mesitylene, xylene, toluene, tetrahydrofuran (THF), dimethylformamide (DMF), dimethylsulfoxide (DMSO), and acetonitrile. In particular, aromatic organic solvents, such as anisole, tetralin, mesitylene, xylene, and toluene, are preferable. While low-boiling ketone solvents having a boiling point of 100°C or below, such as methyl ethyl ketone (MEK) and methyl isobutyl ketone (MIBK), are frequently used in varnish or slurry preparation, the cyclic imide resins as the components (A) used in the present invention exhibit low solubility in these ketone solvents and thus the use of such low-boiling ketone solvents is sometimes unfavorable. The organic solvents may be used alone, or two or more of them may be used in combination.

The heat-curable resin composition of the present invention may be produced by a method of, for example, mixing the components (A), (B), (C), (D), (E), and (F), and optionally other additives as required using, for example, a planetary mixer (manufactured by INOUE MFG., INC.) or stirring machine THINKY CONDITIONING MIXER (manufactured by THINKY CORPORATION). In this process, it is preferable to use an approach that avoids applying excessive load to prevent the component (F) from being broken.

The heat-curable resin composition can be formed into an uncured resin sheet or an uncured resin film by applying the above-described varnish to a substrate and evaporating the organic solvent. Furthermore, the uncured resin sheet or the uncured resin film can be cured to provide a cured resin sheet or a cured resin film. An exemplary method for producing such sheets and films is illustrated below, but the production method is not limited thereto.

For example, the heat-curable resin composition dissolved in an organic solvent (a varnish) is applied onto a substrate, and the coating is heated usually at a temperature of 80°C or above, preferably 100°C or above, for 0.5 to 20 minutes to remove the organic solvent, and is further heated at a temperature of 130°C or above, preferably 150°C or above, for 0.5 to 10 hours to form a strong cured resin film having a flat surface. The temperatures in the drying step for removing the organic solvent and in the subsequent thermal curing step may be each constant but are preferably each raised stepwise. In this manner, the organic solvent can be efficiently removed from the composition, and the curing reaction of the resin can proceed efficiently. For example, the varnish may be applied by a method using a spin coater, a slit coater, a spray coater, a dip coater, or a bar coater, although not particularly limited thereto.

The substrate may employ a conventional resin substrate, and examples thereof include polyolefin resins, such as polyethylene (PE) resin, polypropylene (PP) resin, and polystyrene (PS) resin, and polyester resins, such as polyethylene terephthalate (PET) resin, polybutylene terephthalate (PBT) resin, and polycarbonate (PC) resin. The surface of the substrate may be subjected to release treatment. The thickness of the coating layer is not particularly limited, but the thickness after solvent removal is in the range of 1 to 200 µm, preferably 3 to 150 µm. Furthermore, a cover film may be used on the coating layer. In another embodiment, the components may be premixed beforehand and extruded, using a melt kneader, into a sheet or film shape, which may be used as it is.

The film obtained as described above may be used as a bonding film or a build-up film. Such bonding film may be used between a flexible printed wiring board core material and a cover lay film, or between an organic board and a build-up film. The build-up films are used in laminate or printed wiring board fabrication processes called the semi-additive process (SAP) or the modified semi-additive process (M-SAP).

Here, a resin-coated copper foil may be fabricated by using a copper foil as the substrate and forming an uncured or semi-cured film on the copper foil in the similar manner as described above. Alternatively, a resin-coated copper foil may be obtained by a series of steps in which the heat-curable resin is dissolved into an organic solvent in the similar manner as described above to provide a varnish, which is then applied to a release-treated polyethylene terephthalate (PET) film, the solvent is evaporated to prepare a film, the film is laminated to a copper foil, and the PET film is removed. The laminating conditions in this process are not particularly limited, but the film is preferably laminated while performing heating at a heating temperature of 80 to 130°C, 0.1 to 1.0 MPa, for 0.5 to 5 minutes.

The copper foil to be used may have any degree of roughness which is not limited. From the point of view of reducing the conductor loss, however, it is preferable to use a copper foil that has a 10-spot average roughness (Rz) of 1.5 µm or less on the surface in contact with the uncured or semi-cured heat-curable resin. To reduce the conductor loss, a small average roughness Rz is preferred and the average roughness Rz is preferably 1.3 µm or less, and more preferably 1.0 µm or less. On the other hand, a small Rz material is less effective in anchoring and the adhesion tends to be lowered. However, the heat-curable resin composition of the present invention has high adhesion and thus can be used on such a low roughness copper foil.

The copper foil to be used may be produced by any method without limitation. In general, copper foils are frequently produced by electrolysis or rolling, and electrolytic copper foils produced by electrolysis are frequently used. Furthermore, the copper foil to be used may be surface-treated to attain enhanced properties in respect of, for example, adhesion, heat resistance, and chemical resistance.

The thickness of the copper foil is not particularly limited. Those copper foils having a thickness in the range of 6 to 50 µm are normally used. Thinner copper foils may be used in the form known as copper foils with carriers. Carriers are attached to the thin copper foils to add a thickness to improve handling properties, which are then removed in a downstream processe.

In addition, the heat-curable resin composition of the present invention in the form of varnish may be caused to impregnate a fibrous substrate, such as a glass cloth made of E-glass, low-permittivity glass, quartz glass, or the like, and the organic solvent may be removed to form it into a semi-cured state to thereby use it as a prepreg. Furthermore, such prepreg(s), copper foil(s), and the like may be stacked to form a laminate or a printed wiring board that may have a highly multilayered structure.

The prepreg includes a heat-curable resin and a fibrous substrate. The heat-curable resin is the heat-curable resin composition described hereinabove or a semi-cured product of the resin composition. The term "semi-cured product" refers to a product of the resin composition that has been cured to such an extent that the product still has a room for further curing. That is, the semi-cured product is in a semi-cured state, and is a so-called B-staged product, of the resin composition. On the other hand, the uncured state is sometimes termed as the A-stage. That is, the heat-curable resin may be the heat-curable resin composition in the A-stage, or may be the heat-curable resin composition in the B-stage. The fibrous substrate may be, as described above, of E-glass, low-permittivity glass, or quartz glass, or may be, for example, of S glass or T glass. Any type of glass may be used without being particularly limited, but a quartz glass cloth having low dielectric properties is preferable in order to take advantage of the properties of the heat-curable resin composition. The thickness of generally used fibrous substrates is, for example, 0.01 mm or more and 0.3 mm or less.

In the production of prepregs, it is preferable that the heat-curable resin be in the form of varnish described above in order to ensure that the resin will impregnate a fibrous substrate as the prepreg substrate. For example, the prepreg is produced in such a manner that the heat-curable resin composition prepared as a varnish is caused to impregnate a fibrous substrate and is then dried. The heat-curable resin is caused to impregnate the fibrous substrate by, for example, immersion or coating. Where necessary, the impregnation may involve repeated applications several times. In this process, multiple types of resin composition with different formulations or different concentrations may be used to repeatedly impregnate the fibrous substrate with such resin compositions so that the final product will have the desired formulation and the desired amount of impregnation. The fibrous substrate impregnated with the resin composition (the resin varnish) is heated under desired heating conditions, for example, 80°C or above and 180°C or below for 1 minute or more and 20 minutes or less. The heating provides a prepreg including the A-staged or B-staged heat-curable resin. The heating evaporates the organic solvent from the varnish and can reduce the amount of or remove the organic solvent.

A laminate according to an aspect of the present invention is a stack that is formed by laminating an insulating layer containing or consisting of a cured product of the heat-curable resin composition, and a layer other than the insulating layer one after another. Laminates that are generally well known are metal-clad laminates, in particular, copper-clad laminates. A metal-clad laminate includes an insulating layer including or consisting of a cured product of the heat-curable resin composition, and metal foils disposed on both sides of the insulating layer. The laminate may be a single-sided metal-clad laminate having a metal foil only on one side of the insulating layer. The insulating layer may consist of a cured product of the heat-curable resin composition or a cured product of the prepreg, or may be a stack including multiple layers of cured products of the prepregs. A copper-clad laminate may be fabricated using the resin-coated copper foil. Alternatively, a metal-clad laminate may be fabricated by preparing a cured product of the prepreg beforehand, and laminating a metal foil via a bonding film consisting of the heat-curable resin composition, between the cured product and the metal foil.

Such laminates may be produced by any conventional methods which are not particularly limited. When, for example, the prepreg is used, a single sheet of the prepreg or a stack of sheets of the prepregs may be provided, and a metal foil, such as copper foil, may be placed on both or one of the top and the bottom of the sheet or the stack, which are then hot pressed to integrate the stacked layers, thus providing a laminate.

A printed wiring board according to an aspect of the present invention includes a cured product of the heat-curable resin composition. The insulating layers in the metal-clad laminates for producing the printed wiring board may be layers produced using the prepregs described hereinabove. The printed wiring board may be produced by forming circuits and bonding the layers into a multilayer structure by a known process including cutting holes in the metal-clad laminates, metallization, and etching the metal foils.

The production of the printed wiring board may further include (1) a step of cutting holes in the insulating layers, (2) a step of roughening the insulating layers, and (3) a step of forming conductive layers. The steps (1) and (3) may be performed in accordance with known processes used for manufacturing printed wiring boards.

The step (1) is a step of cutting holes in the insulating layers. By this step, holes, such as via holes or through holes, may be formed in the insulating layers. The step (1) may involve, for example, a drill, a laser, or plasma in accordance with, for example, the formulation of the resin composition used for forming the insulating layers. The dimension and the shape of the holes are determined in accordance with the design of the printed wiring board.

The step (2) is a step of roughening the insulating layers. The insulating layers are roughened while removing (desmearing) resin residues called smears that have been generated in the step (1). The procedures and the conditions in the roughening treatment are not particularly limited, and known procedures and conditions used in the formation of insulating layers in printed wiring boards may be adopted. For example, the insulating layers may be roughened by sequentially performing: swelling treatment with a swelling liquid, roughening treatment with an oxidant, and neutralization treatment with a neutralization solution in this order.

As already described, the recent trend is to reduce the roughness of metal foils, in particular, copper foils for the purpose of reducing the conductor loss. Reducing the roughness weakens anchoring effects and tends to lower the adhesion of the resin layers. Furthermore, separation occurs in the roughening step. These problems will be discussed in detail later.

The swelling liquid used in the roughening treatment is not particularly limited. Examples thereof include alkaline solutions and surfactant solutions, with alkaline solutions being preferable. The solutions that are commercially available may be used. Examples of such commercially available swelling liquids include "Swelling Dip Securiganth P" and "Swelling Dip Securiganth SBU" manufactured by Atotech Japan K.K. The swelling treatment with the swelling liquid may be performed in any manner without limitation. For example, the swelling treatment may be carried out by immersing the insulating layer in the swelling liquid at 30 to 90°C for 1 to 20 minutes. In order to control the swelling of the resin in the insulating layer to an appropriate level, it is preferable that the insulating layer be immersed in the swelling liquid at 40 to 80°C for 5 to 15 minutes.

The oxidant used in the roughening treatment is not particularly limited. Examples thereof include alkaline aqueous permanganate solutions that are aqueous sodium hydroxide solutions into which potassium permanganate or sodium permanganate is dissolved. The roughening treatment with the oxidant, such as an alkaline aqueous permanganate solution, is preferably performed by immersing the insulating layer in the oxidant solution that has been heated to 60 to 100°C, for 10 to 30 minutes. The concentration of the permanganate salt in the alkaline aqueous permanganate solution is preferably 5 to 10% by mass. The solutions commercially available may be used. Examples of the commercially available oxidants include alkaline aqueous permanganate solutions, such as "Concentrate Compact CP" and "Dosing Solution Securiganth P" manufactured by Atotech Japan K.K.

The oxidant dissolves smears but also dissolves the resin layer itself in addition to the smears. As already described, a resin layer formed on a metal surface with low roughness starts to be dissolved by the oxidant while allowing the solution to penetrate into the interface between the metal and the resin layer, and tends to be easily separated. Thus, the resin layer needs to be resistant to the oxidant. If, on the other hand, the oxidant resistance is excessively high, the resin layer cannot be desmeared, which is problematic. Thus, high resistance does not necessarily lead to a favorable outcome. The resin needs to have, for example, appropriate oxidant resistance, adhesion that prevents the penetration of the solution into the interface, and wetting properties with respect to metals.

The neutralization solution used in the roughening treatment is preferably an acidic aqueous solution. Examples of the commercially available neutralization solutions include "Reduction Solution Securiganth P" manufactured by Atotech Japan K.K. The treatment with the neutralization solution may be carried out by immersing the oxidant-roughened surface in the neutralization solution at 30 to 80°C for 1 to 30 minutes. From such a point of view as workability, it is preferable that the oxidant-roughened workpiece be immersed in the neutralization solution at 40 to 70°C for 5 to 20 minutes.

The step (3) is a step of forming conductive layers. The conductive layer is formed on the insulating layer. The conductive materials used in the conductive layers are not particularly limited. In a preferred embodiment, the conductive layer includes one or more metals selected from the group consisting of gold, platinum, palladium, silver, copper, aluminum, cobalt, chromium, zinc, nickel, titanium, tungsten, iron, tin, and indium. The conductive layer may be a single-metal layer or an alloy layer. Examples of the alloy layers include layers formed of alloys of two or more metals selected from the above group (for example, nickel-chromium alloy, copper-nickel alloy, and copper-titanium alloy). In particular, from such points of view as general versatility in conductive layer formation, cost effectiveness, and ease of patterning, preferred layers are single-metal layers of chromium, nickel, titanium, aluminum, zinc, gold, palladium, silver, or copper, and alloy layers of nickel-chromium alloy, copper-nickel alloy, or copper-titanium alloy. More preferred layers are single-metal layers of chromium, nickel, titanium, aluminum, zinc, gold, palladium, silver, or copper, and alloy layers of nickel-chromium alloy. Single-metal layers of copper are still more preferable.

The conductive layer may be of a single-layer structure or may be of a multilayer structure that includes a stack of two or more single-metal layers or alloy layers of different types of metals or alloys. When the conductive layer is a multilayer structure, the layer in contact with the insulating layer is preferably a single-metal layer of chromium, zinc, or titanium, or an alloy layer of nickel-chromium alloy. The thickness of the conductive layer varies depending on the intended design of the printed wiring board but is normally 3 to 35 µm, preferably 5 to 30 µm. The conductive layers may be formed by plating.

### WORKING EXAMPLES

The present invention will be described in greater detail below with reference to working examples and comparative examples. However, the present invention is not limited to the working examples provided below. In the working examples and the comparative examples, the term "room temperature" refers to 25°C.

The components used in the working examples and the comparative examples are illustrated below. In the following description, the values of weight average molecular weight (Mw) were measured by gel permeation chromatography (GPC) relative to polystyrene standards under the following measurement conditions:

### [GPC measurement conditions]

Developing solvent: tetrahydrofuran
Flow rate: 0.35 mL/min
Detector: differential refractometer (RI)
Column: TSK-GEL H type (manufactured by Tosoh Corporation)
Column temperature: 40°C
Sample injection volume: 5 µL (0.2% by mass THF solution)

### [(A) Aromatic cyclic imide resins having a weight average molecular weight of 5,000 to 100,000]

### [Synthesis example 1]

A 1-L four-necked glass flask equipped with a stirrer, a Dean-Stark tube, a cooling condenser, and a thermometer was charged with 65.06 g (0.125 mol) of 2,2-bis[4-(2,3-dicarboxyphenoxy)phenyl]propane dianhydride, 61.59 g (0.150 mol) of 2,2-bis[4-(4-aminophenoxy)phenyl]propane, and 250 g of anisole. The mixture was stirred at 80°C for 3 hours to provide an amic acid. Subsequently, the temperature was raised to 150°C as such and stirring was performed for 2 hours while distilling off the water that had been by-produced to produce a bis-amine-terminated compound. The flask containing the solution of the bis-amine-terminated compound obtained was cooled to room temperature, and subsequently 5.39 g (0.055 mol) of maleic anhydride was added. The mixture was stirred at 80°C for 3 hours to provide a maleamic acid. Subsequently, the temperature was raised to 150°C as such and stirring was performed for 2 hours while distilling off the water that had been by-produced to obtain a varnish of an aromatic bismaleimide compound represented by the formula (A-1) below. The weight average molecular weight (Mw) of the aromatic bismaleimide compound was 25,300. Anisole was added so that the non-volatile content in the varnish would be 25% by mass.

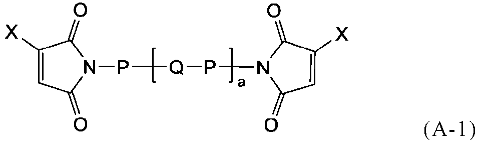

In the formula (A-1), a ≈ 8 (average) and P and Q independently represent divalent groups respectively represented by formulas defined as:
- P:: 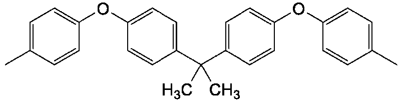
- Q::

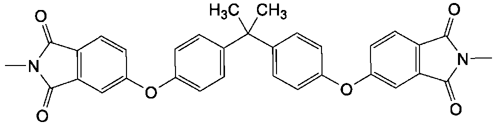

### [Synthesis example 2]

A 1-L four-necked glass flask equipped with a stirrer, a Dean-Stark tube, a cooling condenser, and a thermometer was charged with 65.06 g (0.125 mol) of 2,2-bis[4-(2,3-dicarboxyphenoxy)phenyl]propane dianhydride, 35.26 g (0.115 mol) of 4,4-methylenebis(2,6-diethylaniline), and 250 g of anisole. The mixture was stirred at 80°C for 3 hours to synthesize an amic acid. Subsequently, the temperature was raised to 150°C as such and stirring was performed for 2 hours while distilling off the water that had been by-produced to synthesize a copolymer. The flask containing the copolymer solution was cooled to room temperature, and 7.05 g (0.015 mol) of 2,2-bis[4-(4-aminophenoxy)phenyl]propane was added. The mixture was stirred at 80°C for 3 hours to synthesize an amic acid. Subsequently, the temperature was raised to 150°C as such and stirring was performed for 2 hours while distilling off the water that had been by-produced to thereby synthesize a bis-amine-terminated compound. The flask containing the solution of the bis-amine-terminated compound obtained was cooled to room temperature, and subsequently 1.47 g (0.015 mol) of maleic anhydride was added. The mixture was stirred at 80°C for 3 hours to synthesize a maleamic acid. Subsequently, the temperature was raised to 150°C as such and stirring was performed for 2 hours while distilling off the water that had been by-produced to thereby obtain a varnish of an aromatic bismaleimide compound represented by the formula (A-2) below. The weight average molecular weight (Mw) of the aromatic bismaleimide compound was 30,800. Anisole was added so that the non-volatile content in the varnish would be 25% by mass. 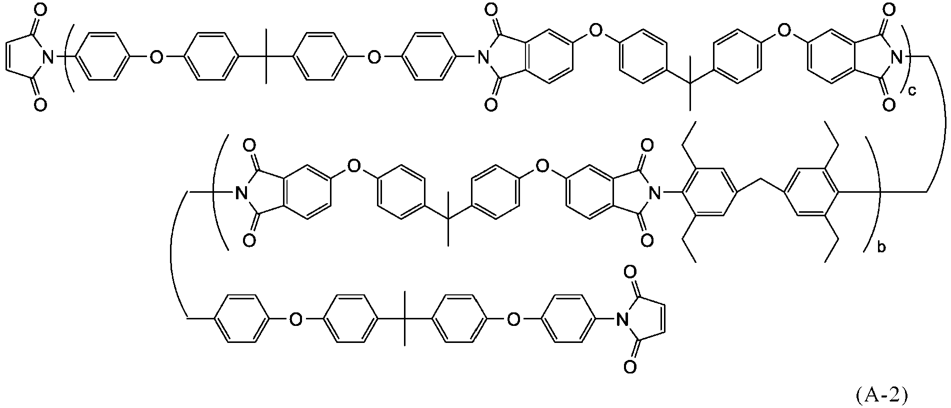 wherein b ≈ 8 (average) and c ≈ 1 (average).

### [Other cyclic imide resins]

(A-3): Bismaleimide compound represented by the formula below (product name: BMI-5000, Mw: 18,000, manufactured by Designer Molecules Inc., for comparative examples) 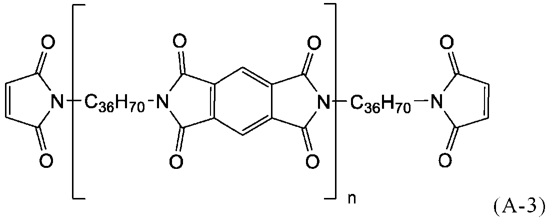 wherein -C₃₆H₇₀- indicates a hydrocarbon group derived from a dimer acid frame and n ≈ 10 (average).
(A-4): Biscitraconimide compound represented by the formula below (Mw: 18,000, for comparative examples) 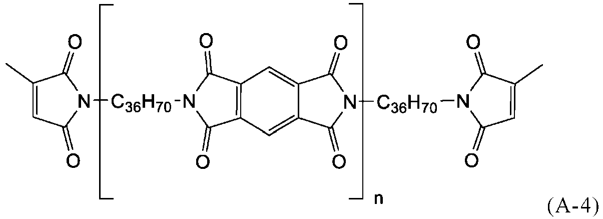 wherein -C₃₆H₇₀- indicates a hydrocarbon group derived from a dimer acid frame and n ≈ 10 (average).
(A-5): 4,4'-Diphenylmethanebismaleimide (BMI-1000, Mw: 520, manufactured by DAIWA KASEI INDUSTRIAL Co., Ltd., for comparative examples)

### [(B) Aliphatic cyclic imide resins having weight average molecular weight of 100 to 2,000]

(B-1): Aliphatic bismaleimide compound represented by the formula below (product name: BMI-TMH, manufactured by DAIWA KASEI INDUSTRIAL Co., Ltd.) (weight average molecular weight: 450) 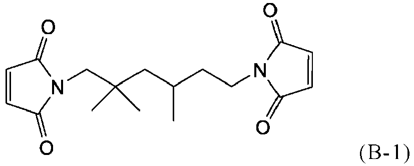
(B-2) Aliphatic biscitraconimide compound represented by the formula below (weight average molecular weight: 470)

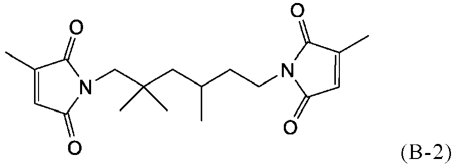

### [(C) Epoxy resins containing two or more epoxy groups in one molecule]

(C-1): Bisphenol A-type liquid epoxy resin (product name: jER-828, manufactured by Mitsubishi Chemical Group Corporation)
(C-2) Aminophenol-type liquid epoxy resin (product name: jER-630, manufactured by Mitsubishi Chemical Group Corporation)

### [(D) Epoxy resin-curing agents]

(D-1): Amine curing agent (4,4'-diaminodiphenylmethane, manufactured by Tokyo Chemical Industry Co., Ltd.)
(D-2): Phenol novolac resin (product name: TD-2131, manufactured by DIC Corporation)

### [(E) Imidazole compounds having triazine frame]

(E-1-1): 2,4-Diamino-6-[2'-undecylimidazolyl-(1')]-ethyl-s-triazine (C11Z-A, manufactured by SHIKOKU KASEI HOLDINGS CORPORATION)
(E-2-1): Dicumyl peroxide (product name: PERCUMYL D, manufactured by NOF CORPORATION, for comparative examples)
(E-2-2): Tetraphenylphosphonium bromide (TPP-PB, manufactured by HOKKO CHEMICAL INDUSTRY CO., LTD., for comparative examples)
(E-2-3): 2-Undecylimidazole (C11Z, manufactured by SHIKOKU KASEI HOLDINGS CORPORATION, for comparative examples)

### [(F) Hollow inorganic fillers]

(F-1): Hollow glass particles (product name: MG-005, manufactured by TAIHEIYO CEMENT CORPORATION, average particle size: 1.6 µm, void content: 80% by volume) treated with an amino group-containing silane coupling agent (product name: KBM-573, manufactured by Shin-Etsu Chemical Co., Ltd.)
(F-2): Hollow silica particles (product name: HS-05, manufactured by Tokuyama Corporation, average particle size: 0.5 µm, void content: 75% by volume) treated with an amino group-containing silane coupling agent (product name: KBM-573, manufactured by Shin-Etsu Chemical Co., Ltd.)

### [(G) Nonhollow inorganic filler]

(G-1): Spherical silica (product name: LVS-512H, manufactured by TATSUMORI LTD., average particle size: 0.5 µm) treated with an amino group-containing silane coupling agent (product name: KBM-573, manufactured by Shin-Etsu Chemical Co., Ltd.)

The components (A) to (G), and a solvent were blended in the amounts described in Tables 1 to 3, and the following evaluations were made. The results are as shown in Tables 1 to 3.

### <Preparation of resin varnishes and compatibility>

The components as shown in Tables 1 to 3 except the component (E) were added in the amounts as shown in Tables 1 to 3 to a 500 mL four-necked flask equipped with a Dimroth condenser and a stirrer. The mixture was stirred at 80°C for 4 hours and was cooled to room temperature, and then the component (E) was added. The resultant mixture was stirred at room temperature for 1 hour and was filtered through a 100-mesh metal screen to provide a resin composition as a varnish. When the varnish was free from separation and was uniform, the compatibility was rated as ∘. When the varnish had separated or any component remained undissolved, the rating was ×. The subsequent evaluations were not performed for the varnishes rated as ×.

While the products obtained in the synthesis examples 1 and 2 were already in the form of varnish, the components contained in the varnishes are separately shown in Tables 1 to 3.

### <Preparation of uncured resin films and handling properties>

The resin varnishes prepared without problems through the above procedures were each applied to a release-treated 50 µm thick PET film (TN-010, manufactured by TOYOBO STC CO., LTD.) using a roller coater, and dried at 100°C for 10 minutes to provide 50 µm thick uncured resin films. To evaluate the handling properties of the uncured resin films obtained, the uncured resin films were cut with a cutter knife. The rating was ∘ when no spilling occurred from the uncured resin, Δ when spilling occurred from the uncured resin, and × when the uncured resin film had been cracked at the time of fabrication.

### <Relative permittivity and dielectric loss tangent>

The above uncured resin film together with the release-treated PET film was fixed on a flat plate, and was cured by being heated at 200°C for 60 minutes to provide a cured resin film. Network analyzer (product name: E5063-2D5, manufactured by Keysight) and a strip line type measurement system (manufactured by KEYCOM Corporation) were connected to the cured resin film to measure the relative permittivity and the dielectric loss tangent at frequencies of 10 GHz and 40 GHz of the cured resin film.

### <Glass transition temperature and coefficient of thermal expansion>

Test samples (cured products) were prepared as described in the above section of relative permittivity and dielectric loss tangent and were analyzed on TMA 450 (manufactured by TA Instruments) to measure and calculate the glass transition temperature and the coefficient of thermal expansion at 0 to 50°C. The cured products were 20 mm × 5 mm × 50 µm in thickness. The measurement was performed at a heating rate of 5°C/min.

### <Peel strength>

A SUS 304 sheet of 75 mm in length, 25 mm in width, and 1.0 mm in thickness was provided, and the uncured resin film on the PET film was placed so that the resin film would be in contact with one side of the SUS 304 sheet. The resin film was laminated at 100°C and 0.3 MPa pressure for 60 seconds. After the lamination, the PET film was removed, and an 18 µm thick copper foil (Ra: 0.17 µm, Rz: 0.6 µm) was placed on the resin film and was laminated at 100°C and 0.3 MPa pressure for 60 seconds. After the lamination, the resin was cured by being heated at 200°C for 60 minutes to thereby fabricate adhesion test specimens. To evaluate bonding properties, the copper foil of each adhesion test specimen was peeled from the SUS 304 sheet while measuring the peel strength (kN/m) at a temperature of 23°C and a tensile rate of 50 mm/min in accordance with JIS C6481: 1996, "Test methods of copper-clad laminates for printed wiring boards".

### <Desmear resistance>

A double-sided copper-clad glass epoxy board (FR-4, product name: R-1075, manufactured by Panasonic Industry Co., Ltd.) of 100 mm in length, 25 mm in width, and 1.0 mm in thickness was provided. As pretreatment, the copper was reduced in a formic acid reflow furnace. The uncured resin film on the PET film was placed so that the resin film would be in contact with one side of the board, and was laminated at 100°C and 0.3 MPa pressure for 60 seconds. After the lamination, the PET film was removed, and the resin was cured by being heated at 200°C for 60 minutes. The cured resin film was cut in accordance with JIS K5600-5-6: 1999 (Adhesion test (Cross-cut test)).

The board having the cured product was immersed in a swelling liquid (product name: Swelling Dip, manufactured by Atotech Japan K.K.) at 60°C for 10 minutes. Next, the board having the cured product was immersed in a roughening solution (product name: Concentrate Compact P, manufactured by Atotech Japan K.K.) at 80°C for 60 minutes. Lastly, the board having the cured product was immersed in a neutralization solution (product name: Reduction Solution Securiganth P, manufactured by Atotech Japan K.K.) at 40°C for 5 minutes. The board having the cured product was water-washed, dried at 120°C for 20 minutes, and visually inspected for separation. The rating was ∘ when there was no separation, and was × when separation was present.

**Table 1**

| Formulations of compositions (parts by mass) | | | Working examples | | | | | | | | | |
|---|---|---|---|---|---|---|---|---|---|---|---|---|
| | | | 1 | 2 | 3 | 4 | 5 | 6 | 7 | 8 | 9 | 10 |
| (A) | Aromatic bismaleimide | A-1 | 70.0 | 70.0 | 70.0 | | 70.0 | 70.0 | 70.0 | 70.0 | 60.0 | 50.0 |
| | Aromatic bismaleimide | A-2 | | | | 70.0 | | | | | | |
| | BMI-5000 | A-3 | | | | | | | | | | |
| | Aliphatic biscitraconimide | A-4 | | | | | | | | | | |
| | BMI-1000 | A-5 | | | | | | | | | | |
| (B) | BMI-TMH | B-2 | 25.0 | 25.0 | 25.0 | 25.0 | 25.0 | | | | | |
| | Aliphatic biscitraconimide | B-3 | | | | | | 25.0 | 25.0 | 25.0 | 35.0 | 45.0 |
| (C) | jER-630 | C-1 | 2.5 | 2.5 | 2.5 | 2.5 | 2.5 | 2.5 | | | | |
| | EPPN-501 | C-2 | | | | | | | 2.5 | 2.5 | 2.5 | 2.5 |
| (D) | Amine curing agent | D-1 | 2.5 | 2.5 | 2.5 | 2.5 | 2.5 | 2.5 | 2.5 | | | |
| | TD-2131 | D-2 | | | | | | | | 2.5 | 2.5 | 2.5 |
| (E) | C11Z-A | E-1-1 | 1.0 | 1.0 | 1.0 | 1.0 | 1.0 | 1.0 | 1.0 | 1.0 | 1.0 | 1.0 |
| | PERCUMYL D | E-2-1 | | | | | | | | | | |
| | TPP-TB | E-2-2 | | | | | | | | | | |
| | C11Z | E-2-3 | | | | | | | | | | |
| (F) | MG-005 | F-1 | 15.0 | 25.0 | 25.0 | 25.0 | | 25.0 | 25.0 | 25.0 | 25.0 | 25.0 |
| | HS-05 | F-2 | | | | | 25.0 | | | | | |
| (G) | LVS-512H | G-1 | | | 75.0 | | | | | | 75.0 | 75.0 |
| (Solvents) | Anisole | | 210.0 | 280.0 | 280.0 | 280.0 | 280.0 | 280.0 | 280.0 | 280.0 | 280.0 | 300.0 |
| | Methyl ethyl ketone (MEK) | | | | | | | | | | | |
| Evaluation results | Compatibility | | ○ | ○ | ○ | ○ | ○ | ○ | ○ | ○ | ○ | ○ |
| | Handling properties | | ○ | ○ | ○ | ○ | ○ | ○ | ○ | ○ | ○ | ○ |
| | Relative permittivity (10 GHz) | | 2.62 | 2.42 | 2.55 | 2.39 | 2.40 | 2.35 | 2.38 | 2.39 | 2.52 | 2.50 |
| | Dielectric loss tangent (10 GHz) | | 0.0033 | 0.0027 | 0.0020 | 0.0026 | 0.0027 | 0.0025 | 0.0029 | 0.0030 | 0.0020 | 0.0018 |
| | Relative permittivity (40 GHz) | | 2.65 | 2.45 | 2.58 | 2.41 | 2.30 | 2.39 | 2.45 | 2.44 | 2.56 | 2.54 |
| | Dielectric loss tangent (40 GHz) | | 0.0034 | 0.0028 | 0.0021 | 0.0027 | 0.0028 | 0.0027 | 0.0035 | 0.0035 | 0.0021 | 0.0020 |
| | Glass transition temperature | °C | 181 | 181 | 181 | 170 | 181 | 174 | 185 | 178 | 178 | 171 |
| | Coefficient of thermal expansion | ppm/K | 50 | 35 | 20 | 28 | 31 | 31 | 31 | 30 | 19 | 19 |
| | Peel strength | kN/m | 1.0 | 0.7 | 0.7 | 0.8 | 0.8 | 1.1 | 0.8 | 0.7 | 0.8 | 0.9 |
| | Desmear resistance test | | ○ | ○ | ○ | ○ | ○ | ○ | ○ | ○ | ○ | ○ |

**Table 2**

| Formulations of compositions (parts by mass) | | | Comparative examples | | | | | | | | | |
|---|---|---|---|---|---|---|---|---|---|---|---|---|
| | | | 1 | 2 | 3 | 4 | 5 | 6 | 7 | 8 | 9 | 10 |
| (A) | Aromatic bismaleimide | A-1 | 70.0 | 70.0 | 70.0 | 70.0 | 70.0 | 70.0 | | | | |
| | Aromatic bismaleimide | A-2 | | | | | | | | | | |
| | BMI-5000 | A-3 | | | | 30.0 | | | 45.0 | 45.0 | | 100.0 |
| | Aliphatic biscitraconimide | A-4 | | | | | 25.0 | | | | | |
| | BMI-1000 | A-5 | | | | | | 30.0 | | | 50.0 | |
| (B) | BMI-TMH | B-2 | 25.0 | 25.0 | 25.0 | | | | 50.0 | 50.0 | 45.0 | |
| | Aliphatic biscitraconimide | B-3 | | | | | | | | | | |
| (C) | jER-630 | C-1 | 2.5 | 2.5 | 2.5 | | 5.0 | | 2.5 | 2.5 | 2.5 | |
| | EPPN-501 | C-2 | | | | | | | | | | |
| (D) | Amine curing agent | D-1 | 2.5 | 2.5 | 2.5 | | | | 2.5 | 2.5 | 2.5 | |
| | TD-2131 | D-2 | | | | | | | | | | |
| (E) | C11Z-A | E-1-1 | 1.0 | 1.0 | 1.0 | | 1.0 | | 1.0 | 1.0 | 1.0 | |
| | PERCUMYL D | E-2-1 | | | | 1.0 | | 1.0 | | | | 1.0 |
| | TPP-TB | E-2-2 | | | | | | | | | | |
| | C11Z | E-2-3 | | | | | | | | | | |
| (F) | MG-005 | F-1 | | | | | | | 25.0 | 25.0 | 25.0 | 25.0 |
| | HS-05 | F-2 | | | | | | | | | | |
| (G) | LVS-512H | G-1 | | 15.0 | 100.0 | 15.0 | 15.0 | 15.0 | | 75.0 | | |
| (Solvents) | Anisole | | 210.0 | 210.0 | 280.0 | 280.0 | 280.0 | 210.0 | 200.0 | 200.0 | 100.0 | 120.0 |
| | Methyl ethyl ketone (MEK) | | | | | | | 100.0 | | | 100.0 | |
| Evaluation results | Compatibility | | ○ | ○ | ○ | × | × | × | ○ | ○ | ○ | ○ |
| | Handling properties | | ○ | ○ | ○ | Not evaluated | Not evaluated | Not evaluated | ○ | ○ | × | ○ |
| | Relative permittivity (10 GHz) | | 2.85 | 2.90 | 3.05 | | | | 2.42 | 2.58 | Not evaluated | 2.31 |
| | Dielectric loss tangent (10 GHz) | | 0.0040 | 0.0039 | 0.0033 | | | | 0.0025 | 0.0017 | | 0.0012 |
| | Relative permittivity (40 GHz) | | 2.95 | 2.99 | 3.09 | | | | 2.41 | 2.55 | | 2.32 |
| | Dielectric loss tangent (40 GHz) | | 0.0051 | 0.0049 | 0.0036 | | | | 0.0026 | 0.0018 | | 0.0012 |
| | Glass transition temperature | °C | 180 | 180 | 181 | | | | 106 | 103 | | 45 |
| | Coefficient of thermal expansion | ppm/K | 63 | 59 | 30 | | | | 98 | 70 | | 120 |
| | Peel strength | kN/m | 1.0 | 0.9 | 0.5 | | | | 1.2 | 1.0 | | 0.9 |
| | Desmear resistance test | | × | × | ○ | | | | **×** | **×** | | × |

**Table 3**

| Formulations of compositions (parts by mass) | | | Comparative examples | | | | |
|---|---|---|---|---|---|---|---|
| | | | 11 | 12 | 13 | 14 | 15 |
| (A) | Aromatic bismaleimide | A-1 | | 100.0 | 70.0 | 70.0 | 70.0 |
| | Aromatic bismaleimide | A-2 | | | | | |
| | BMI-5000 | A-3 | 95.0 | | | | |
| | Aliphatic biscitraconimide | A-4 | | | | | |
| | BMI-1000 | A-5 | | | | | |
| (B) | BMI-TMH | B-2 | | | 25.0 | 250 | 25.0 |
| | Aliphatic biscitraconimide | B-3 | | | | | |
| (C) | jER-630 | C-1 | | | 5.0 | 2.5 | 2.5 |
| | EPPN-501 | C-2 | 5.0 | | | | |
| (D) | Amine curing agent | D-1 | | | | 2.5 | 2.5 |
| | TD-2131 | D-2 | | | | | |
| (E) | C11Z-A | E-1-1 | 1.0 | | 1.0 | | |
| | PERCUMYL D | E-2-1 | | 1.0 | | | |
| | TPP-TB | E-2-2 | | | | 1.0 | |
| | C11Z | E-2-3 | | | | | 1.0 |
| (F) | MG-005 | F-1 | 25.0 | 25.0 | 25.0 | 25.0 | 25.0 |
| | HS-05 | F-2 | | | | | |
| (G) | LVS-512H | G-1 | | | | | |
| (Solvents) | Anisole | | 120.0 | 400.0 | 210.0 | 280.0 | 280.0 |
| | Methyl ethyl ketone (MEK) | | | | | | |
| Evaluation results | Compatibility | | ○ | ○ | ○ | ○ | ○ |
| | Handling properties | | ○ | ○ | ○ | ○ | ○ |
| | Relative permittivity (10 GHz) | | 2.34 | 2.76 | 2.78 | 2.47 | 2.41 |
| | Dielectric loss tangent (10 GHz) | | 0.0017 | 0.0058 | 0.0035 | 0.0034 | 0.0031 |
| | Relative permittivity (40 GHz) | | 2.35 | 2.89 | 2.82 | 2.55 | 2.49 |
| | Dielectric loss tangent (40 GHz) | | 0.0018 | 0.0064 | 0.0042 | 0.0042 | 0.0033 |
| | Glass transition temperature | °C | 45 | 190 | 172 | 167 | 182 |
| | Coefficient of thermal expansion | ppm/K | 120 | 28 | 42 | 35 | 37 |
| | Peel strength | kN/m | 1.1 | 0.3 | 0.5 | 0.4 | 0.3 |
| | Desmear resistance test | | × | × | × | × | ○ |

## Claims

1. A heat-curable cyclic imide resin composition comprising:
(A) an aromatic cyclic imide resin having a weight average molecular weight of 5,000 to 100,000;
(B) an aliphatic cyclic imide resin having a weight average molecular weight of 100 to 2,000;
(C) an epoxy resin containing two or more epoxy groups in one molecule;
(D) an epoxy resin-curing agent;
(E) an imidazole compound having a triazine frame; and
(F) a hollow inorganic filler,
wherein the heat-curable cyclic imide resin composition contains the components (A) to (E) in a total amount of 5 to 99% by mass of the whole composition.

2. The heat-curable cyclic imide resin composition according to claim 1, wherein the aromatic cyclic imide resin (A) comprises one or more aromatic cyclic imides selected from formulas (1) and (2) defined as: 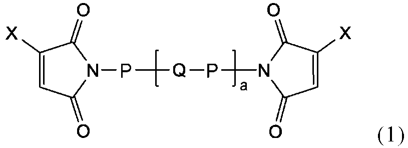
wherein, in the formula (1), a is a number of 1 to 40, X is a hydrogen atom or a methyl group, and P and Q independently represent divalent groups respectively represented by formulas:
P: 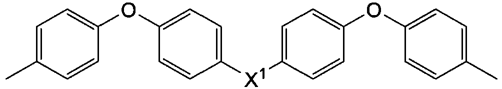
Q: 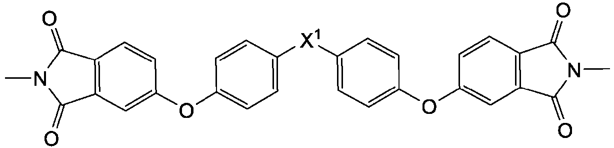
wherein each X¹ independently represents a divalent group selected from formulas listed as 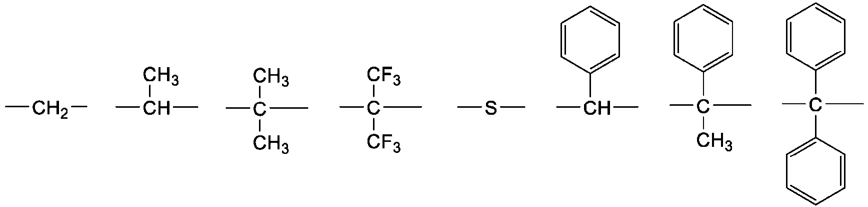 ; and 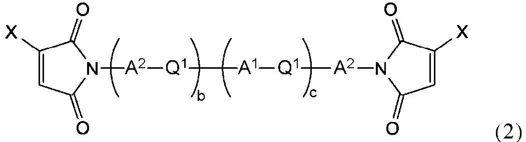
wherein, in the formula (2), X is a hydrogen atom or a methyl group, b is a number of 1 to 50, c is a number of 1 to 50, each Q¹ independently represents a divalent group represented by formula defined as:
Q¹: 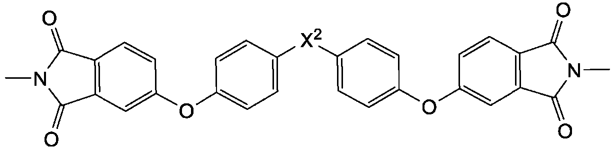
wherein each X² independently represents a divalent group selected from formulas listed as: 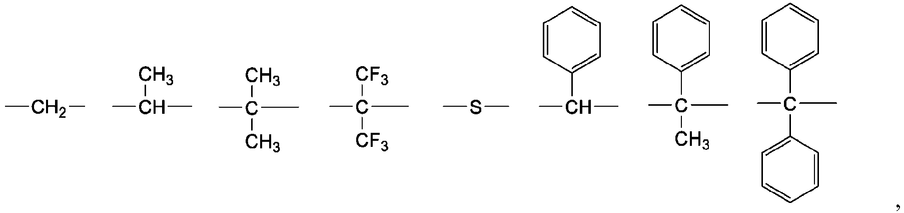 and
wherein A¹ and A² are each independently represented by formula (3) or (4) defined as: 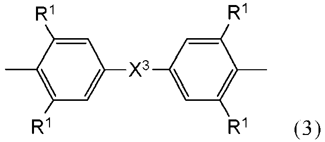 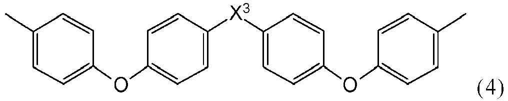 wherein each R¹ in the formula (3) independently represents a hydrogen atom, a chlorine atom, or an aliphatic hydrocarbon group having 1 to 6 carbon atoms and each X³ in the formulas (3) and (4) independently represents a divalent group selected from formulas listed as:

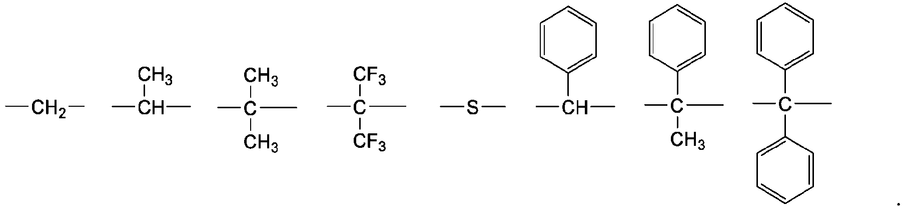

3. The heat-curable cyclic imide resin composition according to claim 1, wherein the aliphatic cyclic imide resin (B) is an aliphatic cyclic imide resin represented by formula (5) defined as: 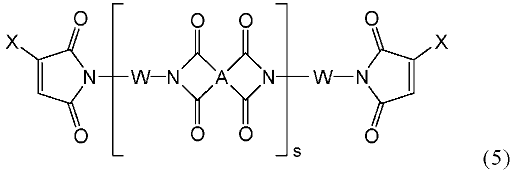 wherein each A independently represents a tetravalent organic group having an aliphatic cyclic structure, X is a hydrogen atom or a methyl group, each W independently represents a divalent aliphatic hydrocarbon group having 5 to 25 carbon atoms and optionally containing a heteroatom, and s is 0 to 10.

4. The heat-curable cyclic imide resin composition according to claim 3, wherein the divalent aliphatic hydrocarbon group represented by W in the formula (5) is a linear or branched alkylene group having 5 to 25 carbon atoms or a divalent aliphatic hydrocarbon group represented by any one of the structural formulas defined as: 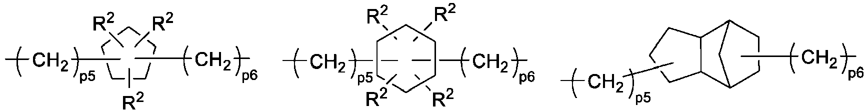 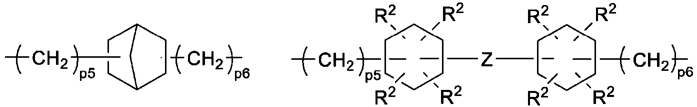 wherein p⁵ and p⁶ are each a number of 0 or greater and are the same as or different from each other, each R² independently represents a hydrogen atom or a linear or branched alkyl group having 1 to 20 carbon atoms, Z is an oxygen atom, a sulfur atom, or a methylene group, and the valence bonds that are not bonded to any substituents in the structural formulas are bonded to the nitrogen atoms constituting the cyclic imide structures in the formula (5).

5. The heat-curable cyclic imide resin composition according to claim 1, wherein the composition contains 5 to 250 parts by mass of the component (B) per 100 parts by mass of the component (A).

6. The heat-curable cyclic imide resin composition according to claim 1, wherein the epoxy resin-curing agent (D) is an amine compound.

7. The heat-curable cyclic imide resin composition according to claim 1, wherein the hollow inorganic filler (F) comprises one or more selected from hollow silica and hollow glass.

8. The heat-curable cyclic imide resin composition according to claim 7, wherein the hollow inorganic filler (F) is treated with a silane coupling agent.

9. The heat-curable cyclic imide resin composition according to claim 1, further comprising (G) a nonhollow inorganic filler.

10. A bonding film comprising the heat-curable cyclic imide resin composition according to any one of claims 1 to 9.

11. A build-up film comprising the heat-curable cyclic imide resin composition according to any one of claims 1 to 9.

12. A resin-coated copper foil comprising the heat-curable cyclic imide resin composition according to any one of claims 1 to 9.

13. A prepreg comprising the heat-curable cyclic imide resin composition according to any one of claims 1 to 9.

14. A laminate comprising the heat-curable cyclic imide resin composition according to any one of claims 1 to 9.

15. A printed wiring board using any one of: the bonding film according to claim 10, the build-up film according to claim 11, the resin-coated copper foil according to claim 12, the prepreg according to claim 13, and the laminate according to claim 14.
